# EUROPEAN PATENT SPECIFICATION

(11) **EP 2 978 296 B1**
(45) Date of publication and mention of the grant of the patent: **21.08.2019**
(21) Application number: 13878626.4
(22) Date of filing: 18.03.2013
(51) Int. Cl.: H05K 13/04, H05K 13/08

(54) **COMPONENT MOUNTING DEVICE AND METHOD OF CALIBRATION IN COMPONENT MOUNTING DEVICE**
KOMPONENTENANBRINGUNGSVORRICHTUNG UND VERFAHREN ZUR KALIBRIERUNG IN EINER KOMPONENTENANBRINGUNGSVORRICHTUNG
DISPOSITIF DE MONTAGE DE COMPOSANTS ET PROCÉDÉ D'ÉTALONNAGE DANS UN DISPOSITIF DE MONTAGE DE COMPOSANTS

(43) Date of publication of application: 27.01.2016
(73) Proprietor: FUJI Corporation, Chiryu Aichi (JP)
(72) Inventor: ITO, Hidetoshi, Chiryu, Aichi (JP); MIZUNO, Takayuki, Chiryu, Aichi (JP); KAWAI, Hidetoshi, Chiryu, Aichi (JP); TANAKA, Keita, Chiryu, Aichi (JP)
(74) Representative: Grünecker Patent- und Rechtsanwälte PartG mbB
(86) International application number: PCT/JP2013/057615
(87) International publication number: WO 2014/147701

(56) References cited:
- JP-A- H10 326 997
- JP-A- 2000 036 697
- JP-A- 2000 332 033
- JP-A- 2008 085 322
- US-A1- 2006 059 502
- US-A1- 2010 060 724

## Description

### Technical Field

The present invention relates to a component mounting device which mounts components on a printed circuit board and a method for calibration in a component mounting device, and in particular, a component mounting device and a method for calibration in which component recognition and board recognition can be shared by one recognition camera.

### Background Art

In the component mounting device, a mounting head and a board recognition camera are attached to a movable carriage which is movable in the X axis and Y axis directions with respect to a base, and a component recognition camera is fixed to the base. Then, a board mark, which is provided on the printed circuit board that is positioned at a mounting position by a board conveyance device, is recognized using the board recognition camera, and the amount of movement of the movable carriage is positionally corrected based on the recognition position of the board mark. In addition, in the middle of moving the component which is sucked to the suction nozzle from a component supply device to a predetermined coordinate position on the printed circuit board, misalignment and angle deviation of the component with respect to the center of the suction nozzle are recognized using the component recognition camera, and based thereon, the position and the angle of the suction nozzle are corrected. Thereby, it is possible to accurately mount the component which is sucked to the suction nozzle of the mounting head by the component supply device at a predetermined coordinate position on the printed circuit board.

In general, the mounting head is attached so as to be attachable and detachable with respect to the movable carriage, and the mounting head is exchanged according to the type of component which is mounted. Then, when the mounting head is exchanged, work is performed in which the coordinate position of the suction nozzle is calibrated with respect to a reference position. The invention described in PTL 1 is known as an example of this type of component mounting device.

In the invention described in PTL 1, since cameras are provided respectively for component recognition and board recognition, the costs of the component mounting device increase due to providing two cameras, calibration of the two cameras with each other is necessary, and it is easy for image recognition differences to occur due to the effects of aging and the like on each camera. As a solution to this problem, an invention which performs component recognition and board recognition using one camera is described in PTL 2. US 2006/059502 A1 discloses a mounting system with a single camera mounted to a movable carriage in which a mounting head is provided. The camera, via two focal planes, is able to capture an image of a component and an image of a board at different positions of the movable carrier.

### Citation List

### Patent Literature

PTL 1: Japanese Patent No. 4322092
PTL 2: Japanese Patent No. 3187976

### Summary of Invention

### Technical Problem

However, since the invention in PTL 2 is configured by a 45° mirror 34, which reflects an image of a component A that is sucked to an suction nozzle 32, is disposed in a gap for vertical movement of the suction nozzle 32 in a horizontal direction, when the component A, which is sucked to the suction nozzle 32, is mounted on a printed circuit board P, it is necessary for the 45° mirror 34 to retreat outside the gap for vertical movement of the suction nozzle 32 by a movement means 35. Moreover, in the invention described in PTL 2, there is a problem in that it is difficult to calibrate the center position of the suction nozzle 32 with respect to the center of a recognition camera (capturing device) 38 in a case where a mounting head 31 is exchanged with respect to a movable carriage (X-Y stage) 2.

The present invention is carried out in consideration of the above circumstances, and an object thereof is to provide a component mounting device and a method for calibration in a component mounting device, in which it is possible to easily perform calibration accompanying exchange of a mounting head or the like by performing component recognition and board recognition using one recognition camera and being able to capture a fiducial mark which is provided on the mounting head side and a fiducial mark which is provided on the base side using the recognition camera.

### Solution to Problem

In order to solve the above problems, an aspect of the invention according to Claim 1 is a component mounting device including: a base which holds a printed circuit board so as to be positioned at a mounting position; a movable carriage which is supported so as to be movable in the X axis direction and the Y axis direction with respect to the base; a mounting head which is attached to the movable carriage so as to be attachable and detachable, has an suction nozzle which sucks a component that is supplied by a component supply device, and is mounted on the printed circuit board on which the component that is sucked to the suction nozzle is held so as to be positioned at the mounting position; and a recognition camera which is integrally provided with the movable carriage, wherein a board recognition optical path which recognizes a board mark that is provided on the printed circuit board from above and a component recognition optical path which recognizes a component sucked to the suction nozzle from below are separately provided with respect to the optical axis of the recognition camera, a first fiducial mark to be captured via the board recognition optical path is provided at a first predetermined position on the base side, a second fiducial mark to be captured via the component recognition optical path is provided at a second predetermined position on the mounting head side, and a calculation means is provided which calculates a calibration value using a positional relationship of the first and second fiducial marks with respect to the optical axis of the recognition camera by capturing the first fiducial mark and the second fiducial mark using the recognition camera. According to the invention in Claim 1, it is possible to easily perform calibration of a coordinate position of an suction nozzle with respect to a reference position in a case where the mounting head is exchanged by capturing the first fiducial mark and the second fiducial mark via the board recognition optical path and the component recognition optical path using one recognition camera. Moreover, since it is possible to perform board recognition and component recognition using one recognition camera, it is possible to reduce the number of cameras, it is possible to reduce the cost of the component mounting device, and it is possible to reduce the size of the mounting head.

An aspect of the invention according to Claim 2 is the component mounting device described in Claim 1, in which the length of the board recognition optical path and the length of the component recognition optical path are the same. According to the invention in Claim 2, it is possible to accurately recognize the first fiducial mark and the second fiducial mark via the board recognition optical path and the component recognition optical path of the same length.

An aspect of the invention according to Claim 3 is the component mounting device described in Claim 1, in which the length of the board recognition optical path and the length of the component recognition optical path are different, and the focal distances thereof are adjusted using a relay lens. According to the invention in Claim 3, it is possible to match the focal distances of the board recognition optical path and the component recognition optical path using the relay lens.

An aspect of the invention according to Claim 4 is the component mounting device described in any one of Claims 1 to 3, in which a second mirror unit, which has the component recognition optical path, is provided so as to be separable with respect to a first mirror unit which has the board recognition optical path, and the second mirror unit is able to be exchanged to match the exchange of the mounting head. According to the invention in Claim 4, it is possible to exchange the second mirror unit with one matching the mounting head by separating only the second mirror unit from the mirror units when exchanging the mounting head.

An aspect of the invention according to Claim 5 is the component mounting device described in any one of Claims 1 to 4, in which the first fiducial mark is provided on a fixed rail at the mounting position. According to the invention in Claim 5, it is possible to calibrate the coordinate position of the suction nozzle by referencing an approximate position of the printed circuit board which is held so as to be positioned at the mounting position by the board conveyance section or the like.

An aspect of the invention according to Claim 6 is the component mounting device described in any one of Claims 1 to 5, in which the mounting head is provided with a plurality of suction nozzles on the circumference, and is provided with a rotary head which is able to index the suction nozzles at the component mounting position and the component capturing position, and a lifting apparatus which lifts the suction nozzles that are indexed at the component mounting position. According to the invention in Claim 6, it is possible to capture a component which is sucked to the suction nozzle that is simultaneously indexed at the component capturing position while sequentially sucking components using the suction nozzle which is positioned on the component mounting position using the recognition camera, and it is possible to effectively perform mounting work of the component.

An aspect of the invention according to Claim 7 is a method for calibration in a component mounting device, the device having: a base which holds a printed circuit board so as to be positioned at a mounting position; a movable carriage which is supported so as to be movable in the X axis direction and the Y axis direction with respect to the base; a mounting head which is attached to the movable carriage so as to be attachable and detachable, has an suction nozzle which sucks a component that is supplied by a component supply device, and is mounted on the printed circuit board on which the component that is sucked to the suction nozzle is held so as to be positioned at the mounting position; and a recognition camera which is integrally provided with the movable carriage, the method including: separating a board recognition optical path which recognizes a board mark that is provided on the printed circuit board, and a component recognition optical path which recognizes a component sucked to the suction nozzle with respect to the optical axis of the recognition camera; and calibrating a coordinate position of the suction nozzle when mounting components by obtaining a positional relationship of the first and second fiducial marks with respect to the optical axis of the recognition camera, and calculating a calibration value of the coordinate position of the suction nozzle with respect to the coordinate position of the first fiducial mark based on the positional relationship of the first and second fiducial marks by capturing the first fiducial mark which is provided on the base side and the second fiducial mark which is provided on the mounting head side using the recognition camera via the board recognition optical path and the component recognition optical path. According to the invention in Claim 7, it is possible to easily perform calibration of the coordinate position of the suction nozzle with respect to the reference position in a case where the mounting head is exchanged by capturing the first fiducial mark and the second fiducial mark via the board recognition optical path and the component recognition optical path using one recognition camera.

### Brief Description of Drawings

Fig. 1 is a perspective view illustrating the entirety of a component mounting device according to an embodiment of the present invention.
Fig. 2 is a perspective view illustrating a mounting head.
Fig. 3 is a view illustrating a configuration of the mounting head.
Fig. 4 is a view illustrating a recognition camera.

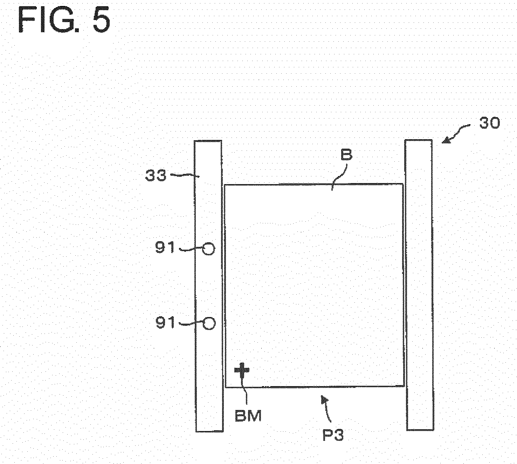

Fig. 5 is a view illustrating a first fiducial mark on a base side.
Fig. 6 is a view illustrating a second fiducial mark on the mounting head side viewed from the direction of arrow 6 in Fig. 4.
Fig. 7 is a block view of a control device which controls the component mounting device.
Fig. 8 is a view illustrating a method for calibration of a suction nozzle.
Fig. 9 is a view illustrating a modified example of the present invention.

### Description of Embodiments

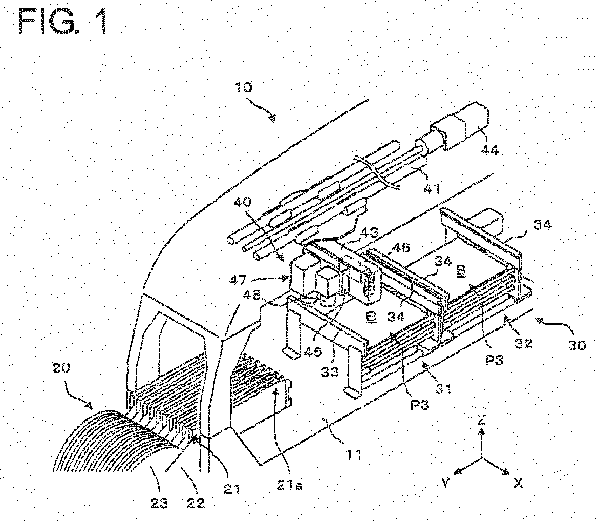

Embodiments of the present invention will be described below with reference to the drawings. As shown in Fig. 1, a component mounting device 10 is provided with a component supply section 20, a board conveyance section 30, and a component transfer section 40.

The component supply section 20 is formed with a configuration, for example, in which a plurality of tape feeders 21 on a base 11 are parallel in the X axis direction. The tape feeders 21 are attachably and detachably mounted to a main body frame 22 which is removably attached to the base 11, and have a supply reel 23 around which a tape, which is accommodated in one row, is wound by having multiple electronic components in a gap. Although not shown in the drawings, a motor, which is a driving source in which the tape is pitch fed, is built-in to the tape feeder 21, the tape is fed out per one pitch by the motor, and the electronic components which are accommodated on the tape are sequentially supplied to a component supply position 21a that is provided at the distal end section of each tape feeder 21.

Since the board conveyance section 30 conveys a circuit board B in the X axis direction and is held so as to be positioned at a predetermined mounting position P3, for example, the board conveyance section 30 is configured as a dual lane type provided with two parallel rows of conveyance lanes 31 and 32 lined up in the Y direction which is orthogonal to the X axis direction. One conveyance rail 31 is provided horizontally facing parallel to a fixed guide rail 33 and a movable guide rail 34, and the other conveyance rail 32 is provided horizontally facing parallel to a pair of movable guide rails 34. A pair of conveyor belts (not shown in the drawings) which supportedly convey the circuit board B which is guided by the guide rails 33 and 34 are provided parallel to the conveyance lanes 31 and 32.

The component transfer section 40 is formed of an XY robot, the XY robot is mounted on the base 11 and disposed above the component supply section 20 and the board conveyance section 30, and is provided with a Y-axis slide 43 which is movable in the Y axis direction along the guide rail 41. The movement of the Y-axis slide 43 in the Y axis direction is controlled by a servo motor 44 via a ball screw. An X-axis slide 45 is supportedly guided so as to be movable in the X axis direction in the Y-axis slide 43, and movement of the X-axis slide 45 in the X axis direction is controlled by a servo motor 46 via a ball screw. Here, a linear motor may be used in place of the ball screw and the servo motor 46. The X-axis slide 45 described above configures a movable carriage which is movable in the X axis direction and the Y axis direction.

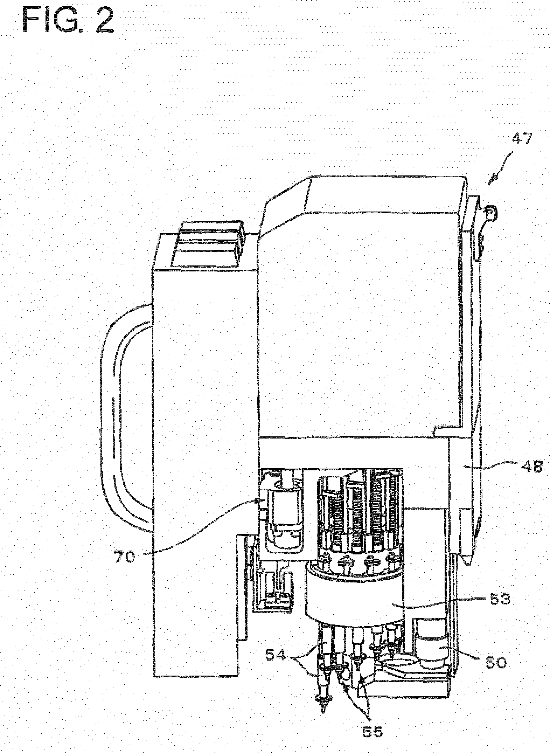

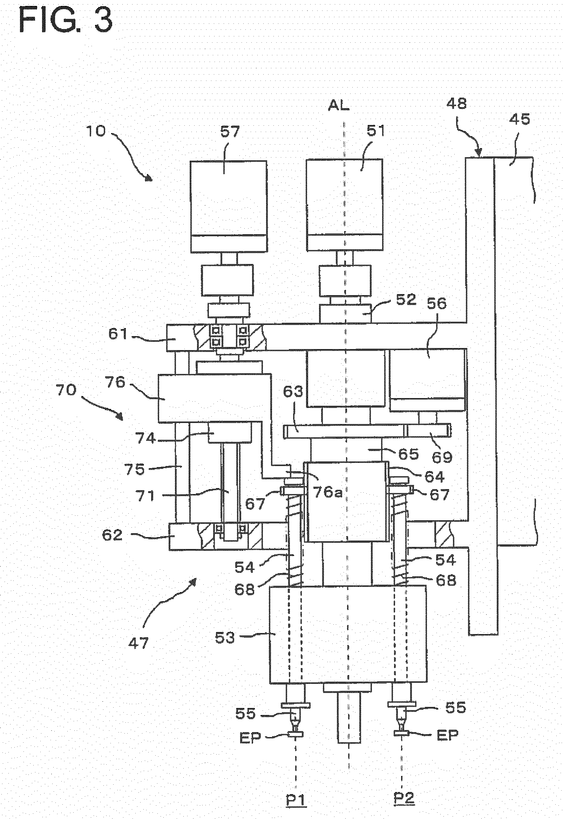

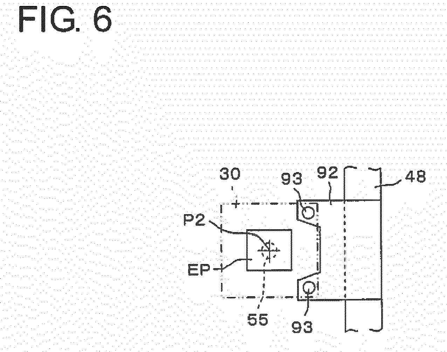

As shown in Fig. 2 and Fig. 3, a head main body 48 of the mounting head 47, which sucks an electronic component EP and mounts it on the circuit board B, is attached on the movable carriage (X-axis slide) 45 so as to be attachable and detachable. In addition, a recognition camera 50 which is formed of a CCD camera is fixed to the movable carriage 45 with its lens in a downward orientation. The recognition camera 50 is common to recognition of a board mark BM (refer to Fig. 6 and the like) which is formed on the electronic component which is sucked to the suction nozzle, which will be described later, and the circuit board B.

As shown in Fig. 3, the mounting head 47 is configured with an R-axis motor 51, an index axis 52, a rotary head 53, a nozzle holder 54, a suction nozzle 55, a θ-axis motor 56, a Z-axis motor 57, and the like. First and second frames 61 and 62 which extend in a horizontal direction are integrally provided on the head main body 48 separated in the vertical direction, and the R-axis motor 51 is fixed to the first frame 61. Here, illustration of the recognition camera 50 is omitted from Fig. 3.

The index axis 52, which is supported so as to be able to rotate around a vertical axis line AL (R axis direction) in the first frame 61, is connected to an output axis of the R-axis motor 51. A rotating body 65 which forms a driven gear 63 and a θ axis gear 64 is supported so as to only be rotatable on the index axis 52. The rotary head 53 is fixed to a lower end section of the index axis 52.

A plurality (N) of nozzle holders 54 are held so as to be movable in the vertical direction (Z axis direction) on the circumference on the same center as the vertical axis line AL on the rotary head 53. The suction nozzle 55, which sucks the electronic components EP, are respectively held on the lower end of each nozzle holder 54. The nozzle gears 67 which mesh with the 0 axis gear 64 are respectively fixed to the upper end section of the nozzle holder 54, and a compression spring 68 is provided between the nozzle gears 67 and the upper end of the rotary head 53. The nozzle holder 54 and the suction nozzle 55 are biased upward by the compression spring 68, and N nozzle holder 54 and suction nozzle 55 are normally held at the upper end position.

Thereby, when the R-axis motor 51 is rotated, the rotary head 53, which holds N suction nozzles 55 via the index axis 52, is rotated around the vertical axis line AL (R axis direction), and each suction nozzle 55 is sequentially stopped at N stopping positions.

In the embodiment, one of the N stopping positions is a component mounting position P1 at which the electronic component EP is mounted on the circuit board B, and the component mounting position P1 also serves as a reception position at which the electronic component EP is received from the tape feeder 21. A position which is spaced from the component mounting position P1 by 180 degrees is a component capturing position P2, the electronic component EP, which is sucked to the suction nozzle 55 that is indexed at the component capturing position P2, is captured from below by the recognition camera 50.

The θ-axis motor 56 is fixed to the first frame 61, and a driving gear 69 is fixed to an output axis of the θ-axis motor 56. The driving gear 69 meshes with the driven gear 63 on the rotating body 65 which is supported so as to be rotatable on the index axis 52. In addition, the 0 axis gear 64 is formed along a predetermined length in the axial direction on the rotating body 65, and the θ axis gear 64 meshes so as to be relatively slidable with each of the respective nozzle gears 67 which are fixed to the nozzle holder 54. Thereby, when the θ-axis motor 56 rotates, all of the suction nozzles 55 simultaneously rotate (revolve) with respect to the rotary head 53 via the driving gear 69, the driven gear 63, the θ axis gear 64, and the nozzle gear 67.

In addition, a lifting apparatus 70, which lifts up and down the nozzle holder 54 that is indexed at the component mounting position P1, is provided in the head main body 48. The lifting apparatus 70 sets the Z-axis motor 57 which is fixed to the first frame 61 of the head main body 48 as the driving source, and the output axis of the Z-axis motor 57 is connected to a ball screw axis 71 which is supported so as to be rotatable around an axis line that is parallel to the vertical axis line AL between the frames 61 and 62. A ball nut 74, which exchanges rotary motion of the Z-axis motor 57 with linear motion, is fastened to the ball screw axis 71. The ball nut 74 is fixed to a lifting and lowering member 76. The lifting and lowering member 76 is guided by the ball nut 74 and a guide bar 75.

A pressing section 76a, which presses the nozzle holder 54 downward in the Z axis direction, projects in the lifting and lowering member 76 so as to abut with the upper end of the nozzle holder 54 which is indexed at the component mounting position P1. Thereby, when the Z-axis motor 57 is rotated, the ball screw axis 71 rotates, and the lifting and lowering member 76 lifts up and down so as to be guided by the guide bar 75 via the ball nut 74. When the lifting and lowering member 76 lifts up and down, the nozzle holder 54 and the suction nozzle 55, which are indexed at the component mounting position P1 via the pressing section 76a, are lifted up and down.

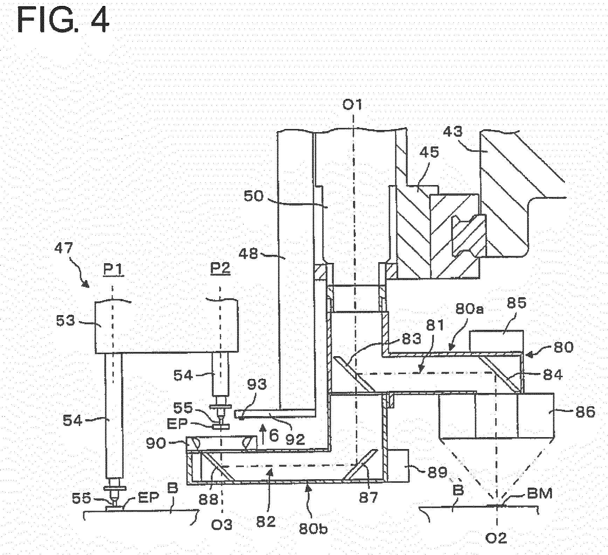

As shown in Fig. 4, a board recognition optical path 81 which recognizes from above the board mark BM that is provided on the circuit board B and a mirror unit 80 which is formed to be separate from the component recognition optical path 82 that recognizes from below the electronic component EP that is sucked to the suction nozzle 55 are provided below the recognition camera 50 with respect to an optical axis O1 of the recognition camera 50. The mirror unit 80 is configured from a first mirror unit 80a with a box form that is formed of the board recognition optical path 81, and a second mirror unit 80b with a box form that is formed of the component recognition optical path 82. The first mirror unit 80a is disposed below the recognition camera 50, and the second mirror unit 80b is fixed below the first mirror unit 80a so as to be separable.

The first mirror unit 80a is formed in an L shape, one end of the L shape is positioned below the recognition camera 50, the other end of the L shape extends in the Y axis direction to be separated from the rotary head 53, and the distal end section is open downward facing the circuit board B. In the same manner, the second mirror unit 80b is formed in an L shape, one end of the L shape is positioned below the recognition camera 50, the other end of the L shape extends in the Y axis direction to come close to the rotary head 53, and the distal end section is open upward extending to directly below the suction nozzle 55 which is positioned at the component capturing position P2.

A first half-silvered mirror 83 which is inclined at 45 degrees with respect to the optical axis O1 of the recognition camera 50, and a second half-silvered mirror 84 which is inclined at 45 degrees to a position a fixed amount in the Y axis direction away with respect to the first half-silvered mirror 83 are built-in to the first mirror unit 80a at a position below the recognition camera 50. In the first mirror unit 80a, an incident light source 85 is provided at a position above the second half-silvered mirror 84, and a side light source 86 in which light is irradiated toward the circuit board B is provided at a position below the second half-silvered mirror 84.

Accordingly, when the incident light source 85 emits light, an image of the board mark BM on the circuit board B which enters from below is reflected in the horizontal direction by the second half-silvered mirror 84, and the reflected image is further reflected upward by the first half-silvered mirror 83, and is incident to the recognition camera 50. Thereby, it is possible to capture the board mark BM on the circuit board B using the recognition camera 50.

Meanwhile, a third half-silvered mirror 87 which is inclined at 45 degrees with respect to the optical axis of the recognition camera 50 below the first half-silvered mirror 83, and a fourth half-silvered mirror 88 which is inclined at 45 degrees to the component capturing position P2 a fixed amount in the Y axis direction from the third half-silvered mirror 87 are built-in to the second mirror unit 80b. In the second mirror unit 80b, an incident light source 89 is provided at a position at the side of the third half-silvered mirror 87, and a side light source 90 which irradiates light toward the electronic component EP which is sucked to the suction nozzle 55 is provided at a position above the fourth half-silvered mirror 88.

Accordingly, when the incident light source 89 emits light, an image of the electronic component EP which enters from above is reflected in the horizontal direction by the fourth half-silvered mirror 88, and the reflected component image is further reflected upward by the third half-silvered mirror 87, and is incident to the recognition camera 50. Thereby, it is possible to capture the electronic component EP which is sucked to the suction nozzle 55 using the recognition camera 50.

Using one recognition camera 50 in this manner, there is a configuration in which it is possible to recognize the board mark BM which is formed on the circuit board B from above via the board recognition optical path 81, and it is possible to recognize the electronic component EP from below which is sucked to the suction nozzle 55 via the component recognition optical path 82.

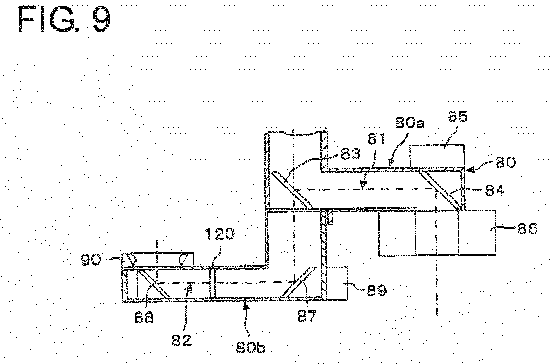

In order to match the focal distances of the board recognition optical path 81 and the component recognition optical path 82 at which the circuit board B and the electronic components EP are captured, each of the optical path lengths are set to be the same. However, in a case where a difference is generated in the optical path lengths, as shown in Fig. 9, it is possible to adjust the focal distances by providing a relay lens 120 in the middle of the board recognition optical path 81 or the component recognition optical path 82. Here, optical glass or a liquid lens may be used in place of the relay lens 120.

Two fiducial marks 91 are formed at a predetermined position at the base 11 side, for example, at a position which is separated by a predetermined amount in the conveyance direction of the circuit board B (X axis direction) on the fixed guide rail 33 of the board conveyance section 30. Since the fiducial marks 91 are captured using the recognition camera 50 for measuring a coordinate position with respect to the reference position of the suction nozzle 55 of the mounting head 47 which is mounted to the movable carriage (X-axis slide) 45 prior to driving of the component mounting device 10 starting, it becomes possible to calculate the positional relationship of the fiducial marks 91 with respect to the optical axis O1 of the recognition camera 50 by processing the captured image.

Meanwhile, a mark forming member 92 is fixed to a predetermined position of the head main body 48, and two fiducial marks 93 are formed in the mark forming member 92 by being separated by a predetermined amount in the X axis direction. The fiducial marks 93 are captured simultaneously in the same field Z2 as the electronic component EP is captured by using the recognition camera 50, it is possible to calculate the positional relationship of the fiducial marks 93 with respect to the optical axis O1 of the recognition camera 50, that is, positional deviation and angle deviation of the mounting head 47 in the XY plane by image processing the two captured fiducial marks 93.

In this manner, it is possible to use a fixed reference position (a fixed rail 33) as a reference and calculate the coordinate position and the inclination (positional deviation and angle deviation of the mounting head 47) of the second fiducial marks 93 by calculating the positional relationship of the fiducial mark (hereinafter this fiducial mark is referred to as the first fiducial mark) 91 at the base 11 side with respect to the optical axis of the recognition camera 50 and the fiducial marks (hereinafter these fiducial marks are referred to as the second fiducial marks) 93 at the mounting head 47 side.

Here, since it is possible to obtain the coordinate position of the suction nozzle 55, which is indexed at the center coordinate of the rotary head 53 and the component mounting position P1, with respect to the coordinate position of the second fiducial marks 93 which are formed in the mark forming member 92 that is fixed to a predetermined position of the head main body 48 from a design value, it is possible to recognize the center coordinate of the suction nozzle 55 which is indexed at the component mounting position P1 by recognizing the coordinate positions of the second fiducial marks 93.

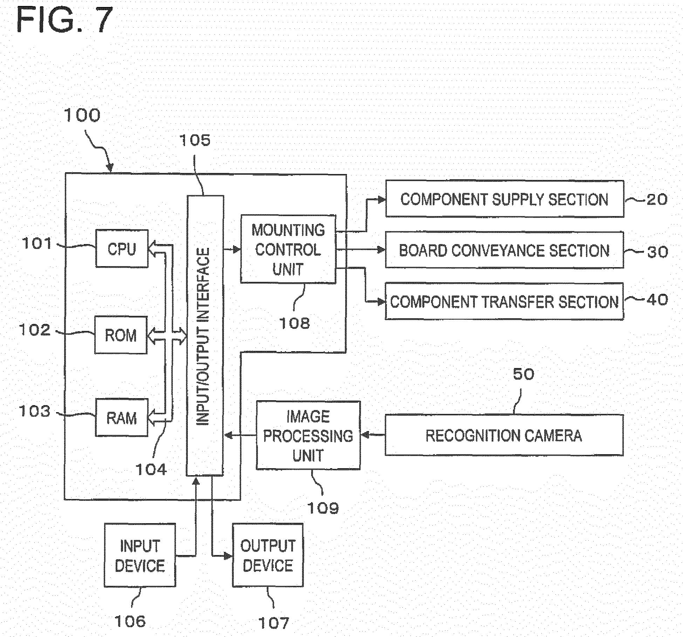

Fig. 7 illustrates a control device 100 which controls the component mounting device 10, and the control device 100 is provided with a CPU 101, a storage device which is formed of a ROM 102 and a RAM 103, and a bus 104 which connects therebetween. An input/output interface 105 is connected to the bus 104, and an input device 106 such as a keyboard or mouse and an output device 107 such as a display unit which performs necessary guidance (display) for an operator are connected to the input/output interface 105.

In addition, a mounting control unit 108 which controls the component supply section 20, the board conveyance section 30 and the component transfer section 40 is connected to the input/output interface 105, and an image processing unit 109 and the like which image processes image data that is captured by the recognition camera 50 is connected to the input/output interface 105. Here, a calibration program which will be described later and the like are stored in the RAM 103 of the control device 100.

In a case where the mounting head 47 is exchanged, it is possible for the control device 100 which controls the component mounting device 10 to calculate the positional relationship of the coordinate position of the first fiducial mark 91 and the coordinate position of the second fiducial marks 93 with respect to the optical axis O1 of the recognition camera 50, and it is possible to recognize the center coordinate of the suction nozzle 55 with respect to the fixed reference position based on the positional relationship, by capturing the first fiducial mark 91 on the base 11 side and the second fiducial marks 93 on the mounting head 47 side using the recognition camera 50 which is attached to the movable carriage 45.

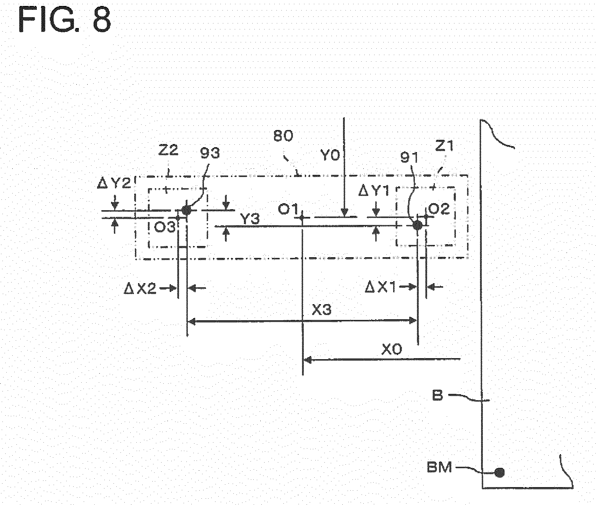

A calibration process in which the coordinate position of the suction nozzle 55 is calibrated is described below based on Fig. 8, but in order to simply the description in Fig. 8, although there are two of each of the first and second fiducial marks 91 and 93, one of each are indicated in the example.

To start, the movable carriage 45 moves in the X axis and Y axis directions, and is positioned at a position where it is possible to capture the first fiducial mark 91 which is formed on the fixed rail 33 of the board conveyance section 30 using the recognition camera 50. Amounts of movement X0 and Y0 of the movable carriage 45 with respect to the coordinate origin of the component mounting device 10 at this time are detected by an appropriate position detection device, and are stored in the RAM 103 of the control device 100.

When the movable carriage 45 is positioned at a position where it is possible for the recognition camera 50 to capture the first fiducial mark 91, an image of the first fiducial mark 91 is taken in the recognition camera 50 via the half-silvered mirrors 84 and 83 and subjected to image processing by the image processing unit 109 by temporarily emitting the incident light source 85 and the side light source 86 at the board recognition optical path 81 side. As shown in Fig. 8, by means of the image processing, positional deviations ΔX1 and ΔY1 and the like of the coordinate position of the first fiducial mark 91 are measured with respect to a coordinate center O2 of the image range Z1. At this time, since the incident light source 89 at the component recognition optical path 82 side is turned off, the image of the second fiducial mark 93 is not taken in the recognition camera 50.

Next, an image of the second fiducial mark 93 is taken in the recognition camera 50 via the half-silvered mirrors 88 and 87, and is subjected to image processing by the image processing unit 109 by temporarily emitting the incident light source 89 and the side light source 90 at the component recognition optical path 82 side. As shown in Fig. 8, by means of the image processing, positional deviations ΔX2 and ΔY2 and the like of the coordinate position of the second fiducial mark 93 with respect to a coordinate center O3 of the image range Z2 are measured. Also in this case, since the incident light source 85 at the board recognition optical path 81 side is turned off, the image of the first fiducial mark 91 is not taken in the recognition camera 50.

Accordingly, it is possible to calculate the amount of positional deviation of the coordinate position of the suction nozzle 55 using the CPU 101 of the control device 100 since coordinate positions X3 and Y3, of the second fiducial mark 93 with respect to a fixed reference position (a coordinate position of the first fiducial mark 91) in a state in which the movable carriage 45 is moved from the coordinate origin by only X0 and Y0 and moreover, based on the design value the coordinate position of the center of the suction nozzle 55 which is positioned at the component mounting position P1 can be recognized.

Thereby, it is possible to correct an amount of deviation of a mechanical system in a case where the mounting head 47 is exchanged, by correcting the amount of movement of the movable carriage 45 during component mounting using the amount of calculated positional deviation as a calibration value. Here, in addition to exchanging the mounting head 47, it is also possible to ascertain the amount of deviation of the mechanical system due to the influence of thermal displacement or the like during operation of the machinery and it is possible to correct the deviation by executing a calibration process per each fixed time. A calculation means is configured which calculates a calibration value using the positional relationship of the first and second fiducial marks 91 and 93 with respect to the optical axis of the recognition camera 50 using the CPU 101 described above.

Next, the operation in which the electronic component EP is mounted on the circuit board B, which is held so as to be positioned at the mounting position P3 of the board conveyance section 30 by the calibrated component mounting device 10, will be described.

When the circuit board B is positioned at the mounting position P3 using the board conveyance section 30, the control device 100 moves carriage 45 a predetermined amount in the X axis direction and the Y axis direction to a position such that suction nozzle 55 at the component mounting position P1 corresponds to the component supply position 21a of the specified tape feeder 21 of the component supply section 20. In that state, the electronic components EP are sequentially sucked to a plurality of suction nozzles 55 by alternately repeating intermittent rotation of the rotary head 53 using the R-axis motor 51 and lifting of the nozzle holder 54 using the lifting apparatus 70.

Meanwhile, the electronic component EP which is sucked to the suction nozzle 55 which is indexed at the component capturing position P2 due to intermittent rotation of the rotary head 53 are sequentially captured by the recognition camera 50, and misalignment, angle deviation, and the like of the electronic components EP with respect to the center of the suction nozzle 55 are detected. Angle deviation of the electronic component EP is corrected by the suction nozzle 55 rotating based on the angle deviation, or the amount of movement of the movable carriage 45 in the X axis and Y axis directions is corrected based on the misalignment.

Thereafter, the movable carriage 45 is moved to a position at which it is possible to capture the board mark BM that is formed on the circuit board B using the recognition camera 50. Then, the board mark BM is captured by the recognition camera 50, and positional error of the circuit board B is corrected based on deviation of the board mark BM which is captured by the recognition camera 50. At this time, at the same time, the movable carriage 45 is positionally corrected by a calculated calibration value in the calibration process described above.

Next, the electronic components EP, which are sucked to the suction nozzles 55 that are indexed at the component mounting position P1, are sequentially mounted at specified positions on the circuit board B by alternately repeating intermittent rotation of the rotary head 53 and lifting of the nozzle holder 54. Thereby, the electronic components EP are accurately mounted at predetermined coordinate positions on the circuit board B regardless of positional deviation or the like of the suction nozzle 55 with respect to the reference positions accompanying exchange of the mounting head 47.

According to the component mounting device 10 and the method for calibration according to the embodiments described above, since the first fiducial marks 91 and the second fiducial marks 93 are captured via the board recognition optical path 81 and the component recognition optical path 82 using one recognition camera 50, it is possible to easily perform calibration of the coordinate position of the suction nozzle 55 with respect to a reference position in a case where the mounting head 47 is exchanged. Moreover, since it is possible to perform board recognition and component recognition using one recognition camera 50, it is possible to reduce the number of cameras, it is possible to reduce the cost of the component mounting device 10, and it is possible to reduce the size of the mounting head 47. Additionally, since it is possible to provide the recognition camera 50 so as to be close to the position of the suction nozzle 55, it is possible to reduce the size of the component mounting device 10.

According to the embodiments described above, since the second mirror unit 80b, which has the component recognition optical path 82, is provided so as to be separable with respect to the first mirror unit 80a which has the board recognition optical path 81, and the second mirror unit 80b is able to be exchanged to match the exchange of the mounting head 47, when exchanging the mounting head 47, it is possible to separate only the second mirror unit 80b out of the mirror unit 80, and exchange the second mirror unit 80b with one to match the mounting head 47, or make exchange unnecessary.

According to the embodiments described above, since the first fiducial marks 91 are provided on the fixed rail 33 at the mounting position P3, it is possible to calibrate the coordinate position of the suction nozzle 55 by referencing an approximate position of the circuit board B which is held so as to be positioned at the mounting position P3 by the board conveyance section 30 or the like.

According to the embodiments described above, since the mounting head 47 is provided with a plurality of suction nozzles 55 on the circumference, and is provided with the rotary head 53 which is able to index the suction nozzles 55 at the component mounting position P1 and the component capturing position P2, and the lifting apparatus 70 which lifts the suction nozzles 55 that are indexed at the component mounting position P1, it is possible to simultaneously capture the electronic components EP, which are sucked to the suction nozzles 55 that are indexed at the component capturing position P2, using the recognition camera 50 while sequentially sucking the electronic components EP using the suction nozzles 55 which are positioned at the component mounting position P1, and it is possible to effectively perform mounting work of the electronic components EP.

In the embodiments described above, an example is described in which the mounting head 47 is configured by the rotary head 53 which holds a plurality of suction nozzles 55, but it is also possible to apply the invention in which a mounting head 47 is provided with at least one suction nozzle.

In addition, in the embodiments described above, an example is described in which the first fiducial mark 91 is provided on the fixed rail 33 of the board conveyance section 30, but is not limited to the fixed rail 33, and the first fiducial mark 91 may also be provided at a predetermined position on the base 11.

In addition, in the embodiments described above, it is unnecessary to provide a shutter in the middle of the optical path due to the configuration of the board recognition optical path 81 and the component recognition optical path 82 such that an image of the second fiducial mark 93 (first fiducial mark 91) is not taken by the recognition camera 50 in a case where the first fiducial mark 91 (the second fiducial mark 93) is captured by the recognition camera 50, but the optical path may be configured such that a shutter is provided in the middle of the optical path.

In addition, in the embodiments described above, an example is described in which the mark forming member 92, which forms the second fiducial mark 93, is attached to the head main body 48 of the mounting head 47, and, when calibrating, the second fiducial mark 93 is captured by the recognition camera 50, but a reference nozzle may be attached to the nozzle holder 54 of the mounting head 47 (rotary head 53), and the reference nozzle may calculate the positional relationship of the suction nozzle with respect to the reference position by capturing the reference nozzle using the recognition camera 50.

In addition, in the embodiments described above, an example is described in which the electronic components EP and the board mark BM are captured by the recognition camera 50 which is provided on the mounting head 47 side when mounting components, but in addition to the recognition camera 50, it is also possible to install a camera specialized in component recognition in the base 11 and recognize the electronic components EP using the camera specialized in component recognition according to the electronic component EP. Here, in a case where the camera specialized in component recognition is used, in the same manner as in the related art, it is sufficient if the electronic components EP which are sucked to the suction nozzle 55 are captured while moving from the component supply position 21a of the component supply section 20 to the circuit board B.

In such a manner, the present invention can adopt various forms within a range that does not deviate from the gist of the present invention which is described in the claims.

### Industrial Applicability

A component mounting device according to the present invention is appropriately used to recognize a board mark which is provided on a printed circuit board using one recognition camera, and to recognize a component which is sucked to a suction nozzle.

### Reference Signs List

10 ... COMPONENT MOUNTING DEVICE, 11 ... BASE, 20 ... COMPONENT SUPPLY SECTION, 30 ... BOARD CONVEYANCE SECTION, 33 ... FIXED RAIL, 40 ... COMPONENT TRANSFER SECTION, 45 ... MOVABLE CARRIAGE, 47 ... MOUNTING HEAD, 48 ... HEAD MAIN BODY, 50 ... RECOGNITION CAMERA, 53 ... ROTARY HEAD, 54 ... NOZZLE HOLDER, 55 ... SUCTION NOZZLE, 70 ... LIFTING APPARATUS, 80 (80a, 80b) ... MIRROR UNIT, 81 ... BOARD RECOGNITION OPTICAL PATH, 82 ... COMPONENT RECOGNITION OPTICAL PATH, 83, 84, 87, 88 ... MIRROR, 85, 89 ... INCIDENT LIGHT SOURCE, 86, 90 ... SIDE LIGHT SOURCE, 91 ... FIRST FIDUCIAL MARK, 93 ... SECOND FIDUCIAL MARK, 120 ... RELAY LENS, B ... PRINTED CIRCUIT BOARD, BM ... BOARD MARK, EP ... COMPONENT

## Claims

1. A component mounting device (10) comprising:
a base (11) which holds a printed circuit board (B) so as to be positioned at a mounting position (P3);
a movable carriage (45) which is supported so as to be movable in the X axis direction and the Y axis direction with respect to the base (11);
a mounting head (47) attached to the movable carriage (45) so as to be attachable and detachable with a suction nozzle (55) which sucks a component (EP) supplied from a component supply device (20) and which mounts the component (EP) sucked by the suction nozzle (55) onto the printed circuit board (B) positioned and held at the mounting position (P3) and
a recognition camera (50) which is integrally provided with the movable carriage (45),
**characterized in that**
a board recognition optical path (81) which recognizes a board mark (BM) that is provided on the printed circuit board (B) from above and a component recognition optical path (82) which recognizes a component (EP) sucked to the suction nozzle (55) from below are separately provided with respect to the optical axis (O1) of the recognition camera (50),
a first fiducial mark (91) to be captured via the board recognition optical path (81) is provided at a predetermined position on the base (11) side,
a second fiducial mark (93) to be captured via the component recognition optical path (82) is provided at a predetermined position on the mounting head side, and
a calculation means (101) is provided which calculates a calibration value using a positional relationship of the first and second fiducial marks (91, 93) with respect to the optical axis (O1) of the recognition camera (50) by capturing the first fiducial mark (91) and the second fiducial mark (93) using the recognition camera (50).

2. The component mounting device (10) according to Claim 1, wherein the length of the board recognition optical path (81) and the length of the component recognition optical path (82) are the same.

3. The component mounting device (10) according to Claim 1, wherein the length of the board recognition optical path (81) and the length of the component recognition optical path (82) are different, and the focal distances thereof are adjusted using a relay lens (120).

4. The component mounting device (10) according to any one of Claims 1 to 3, wherein a second mirror unit (80b), which has the component recognition optical path (82), is provided so as to be separable with respect to a first mirror unit (80a) which has the board recognition optical path (81), and the second mirror unit (80b) is capable of being exchanged to match the exchange of the mounting head (47).

5. The component mounting device (10) according to any one of Claims 1 to 4, wherein the first fiducial mark (91) is provided on a fixed rail at the mounting position (P3).

6. The component mounting device (10) according to any one of Claims 1 to 5, wherein the mounting head (47) is provided with a plurality of suction nozzles (55) on the circumference, and is provided with a rotary head (53) which is capable of indexing the suction nozzles (55) at a component mounting position (P1) and a component capturing position (P2), and a lifting apparatus (70) which lifts up and down the suction nozzles (55) that are indexed at the component mounting position (P1).

7. A method for calibration in a component mounting device (10), the device including: a base (11) which holds a printed circuit board (B) so as to be positioned at a mounting position (P3); a movable carriage (45) which is supported so as to be movable in the X axis direction and the Y axis direction with respect to the base (11); a mounting head (47) attached to the movable carriage (45) so as to be attachable and detachable with a suction nozzle (55) which sucks a component (EP) supplied from a component supply device (20) and which mounts the component (EP) sucked by the suction nozzle (55) onto the printed circuit board (B) positioned and held at the mounting position (P3) and a recognition camera (50) which is integrally provided with the movable carriage (45), the method being **characterized by** comprising:
separating a board recognition optical path (81) which recognizes a board mark (BM) that is provided on the printed circuit board (B), and a component recognition optical path (82) which recognizes a component (EP) sucked to the suction nozzle (55) with respect to the optical axis (O1) of the recognition camera (50); and
calibrating a coordinate position of the suction nozzle (55) when mounting components (EP) by obtaining a positional relationship of the first and second fiducial marks (91, 93) with respect to the optical axis (O1) of the recognition camera (50), and calculating a calibration value of the coordinate position of the suction nozzle (55) with respect to the coordinate position of the first fiducial mark (91) based on the positional relationship of the first and second fiducial marks (91, 93) by capturing the first fiducial mark (91) which is provided on the base side and the second fiducial mark (93) which is provided on the mounting head side using the recognition camera (50) via the board recognition optical path (81) and the component recognition optical path (82).

## Patentansprüche

1. Vorrichtung (10) zum Montieren von Bauteilen, die umfasst:
einen Träger (11), der eine Leiterplatte (B) so trägt, dass sie an einer Montageposition (P3) positioniert wird;
einen beweglichen Schlitten (45), der so gelagert ist, dass er in Bezug auf den Träger (11) in der Richtung der X-Achse und der Richtung der Y-Achse bewegt werden kann;
einen Montage-Kopf (47), der an dem beweglichen Schlitten (45) so angebracht ist, dass eine Saugdüse (55) angebracht und entfernt werden kann, die ein von einer Bauteil-Zuführvorrichtung (20) zugeführtes Bauteil (EP) ansaugt, und der das durch die Saugdüse (55) angesaugte Bauteil (EP) auf der Leiterplatte (B) montiert, die an der Montageposition (P3) positioniert ist und gehalten wird, sowie
eine Erkennungs-Kamera (50), die integral an dem beweglichen Schlitten (45) angeordnet ist,
**dadurch gekennzeichnet, dass**
ein Lichtweg (81) zur Erkennung einer Platte, über den eine an der Leiterplatte (B) vorhandene Platten-Markierung (BM) von oben erkannt wird, und ein Lichtweg (82) zur Erkennung eines Bauteils, über den ein an die Saugdüse (55) angesaugtes Bauteil (EP) von unten erkannt wird, separat in Bezug auf die optische Achse (O1) der Erkennungs-Kamera (50) vorhanden sind,
eine erste Bezugs-Markierung (91), die über den Lichtweg (81) zur Erkennung einer Platte erfasst wird, an einer vorgegebenen Position an der Seite des Trägers (11) vorhanden ist,
eine zweite Bezugs-Markierung (93), die über den Lichtweg (82) zur Erkennung eines Bauteils erfasst wird, an einer vorgegebenen Position an der Seite des Montage-Kopfes vorhanden ist, und
eine Berechnungseinrichtung (101) vorhanden ist, die einen Kalibrierungs-Wert unter Verwendung einer Positionsbeziehung der ersten und der zweiten Bezugs-Markierung (91, 93) in Bezug auf die optische Achse (O1) der Erkennungs-Kamera (50) berechnet, indem sie die erste Bezugs-Markierung (91) und die zweite Bezugs-Markierung (93) unter Verwendung der Erkennungs-Kamera (50) erfasst.

2. Vorrichtung (10) zum Montieren von Bauteilen nach Anspruch 1, wobei die Länge des Lichtweges (81) zur Erkennung einer Platte und die Länge des Lichtweges (82) zur Erkennung eines Bauteils gleich sind.

3. Vorrichtung (10) zum Montieren von Bauteilen nach Anspruch 1, wobei die Länge des Lichtweges (81) zur Erkennung einer Platte und die Länge des Lichtweges (82) zur Erkennung eines Bauteils unterschiedlich sind und ihre Brennweiten mittels einer Relaislinse (120) eingestellt werden.

4. Vorrichtung (10) zum Montieren von Bauteilen nach einem der Ansprüche 1 bis 3, wobei eine zweite Spiegel-Einheit (80b), die den Lichtweg (82) zur Erkennung eines Bauteils aufweist, so eingerichtet ist, dass sie von einer ersten Spiegel-Einheit (80a) getrennt werden kann, die den Lichtweg (81) zur Erkennung einer Platte aufweist, und die zweite Spiegel-Einheit (80b) entsprechend dem Austausch des Montage-Kopfes (47) ausgetauscht werden kann.

5. Vorrichtung (10) zum Montieren von Bauteilen nach einem der Ansprüche 1 bis 4, wobei sich die erste Bezugs-Markierung (91) an einer stationären Schiene an der Montageposition (P3) befindet.

6. Vorrichtung (10) zum Montieren von Bauteilen nach einem der Ansprüche 1 bis 5, wobei der Montage-Kopf (47) mit einer Vielzahl von Saugdüsen (55) am Umfang versehen ist und mit einem Dreh-Kopf (53), der in der Lage ist, die Saugdüsen (55) an eine Position (P1) zum Montieren von Bauteilen und an eine Position (P2) zum Erfassen von Bauteilen weiterzurücken, sowie mit einer Hebe-Einrichtung (70) versehen ist, die die Saugdüsen (55) nach oben und nach unten hebt, die an die Position (P1) zum Montieren von Bauteilen weitergerückt werden.

7. Verfahren zur Kalibrierung in einer Vorrichtung (10) zum Montieren von Bauteilen, wobei die Vorrichtung einen Träger (11), der eine Leiterplatte (B) so trägt, dass sie an einer Montageposition (P3) positioniert wird, einen beweglichen Schlitten (45), der so gelagert ist, dass er in Bezug auf den Träger (11) in der Richtung der X-Achse und der Richtung der Y-Achse bewegt werden kann, einen Montage-Kopf (47), der an dem beweglichen Schlitten (45) so angebracht ist, dass eine Saugdüse (55) angebracht und entfernt werden kann, die ein von einer Bauteil-Zuführeinrichtung (20) zugeführtes Bauteil (EP) ansaugt, und der das von der Saugdüse (55) angesaugte Bauteil (EP) auf der Leiterplatte (B) montiert, die an der Montageposition (P3) positioniert ist und gehalten wird, sowie eine Erkennungs-Kamera (50) enthält, die integral an dem beweglichen Schlitten (45) angeordnet ist, wobei das Verfahren **dadurch gekennzeichnet ist, dass** es umfasst:
Trennen eines Lichtweges (81) zur Erkennung einer Platte, über den eine an der Leiterplatte (B) vorhandene Platten-Markierung (BM) erkannt wird, und eines Lichtweges (82) zur Erkennung eines Bauteils, über den ein an die Saugdüse (55) angesaugtes Bauteil (EP) erkannt wird, in Bezug auf die optische Achse (O1) der Erkennungs-Kamera (50); sowie
Kalibrieren einer Koordinaten-Position der Saugdüse (55) beim Montieren von Bauteilen (EP) durch Ermitteln einer Positionsbeziehung der ersten und der zweiten Bezugs-Markierung (91, 93) in Bezug auf die optische Achse (O1) der Erkennungs-Kamera (50) und Berechnen eines Kalibrierungs-Wertes der Koordinaten-Position der Saugdüse (55) in Bezug auf die Koordinaten-Position der ersten Bezugs-Markierung (91) auf Basis der Positions-Beziehung der ersten und der zweiten Bezugs-Markierung (91), 93) durch Erfassen der ersten Bezugs-Markierung (91), die sich an der Seite des Trägers befindet, und der zweiten Bezugs-Markierung (93), die sich an der Seite des Montage-Kopfes befindet, unter Verwendung der Erkennungs-Kamera (50) über den Lichtweg (81) zur Erkennung einer Platte und den Lichtweg (82) zur Erkennung eines Bauteils.

## Revendications

1. Dispositif de montage de composant (10) comprenant :
une base (11) qui maintient une carte de circuit imprimé (B) de manière à être positionnée à une position de montage (P3) ;
un chariot mobile (45) qui est supporté de manière à pouvoir se déplacer dans la direction d'axe X et dans la direction d'axe Y par rapport à la base (11) ;
une tête de montage (47) attachée au chariot mobile (45) de manière à pouvoir être attachée et détachée avec une buse d'aspiration (55) qui aspire un composant (EP) alimenté par un dispositif d'alimentation en composants (20) et qui monte le composant (EP) aspiré par la buse d'aspiration (55) sur la carte de circuit imprimé (B) positionnée et maintenue à la position de montage (P3) et
une caméra de reconnaissance (50) qui est munie intégralement du chariot mobile (45),
**caractérisé en ce que**
un chemin optique de reconnaissance de carte (81) qui reconnaît une marque de carte (BM) qui est établie sur la carte de circuit imprimé (B) par le haut et un chemin optique de reconnaissance de composant (82) qui reconnaît un composant (EP) aspiré dans la buse d'aspiration (55) par le bas sont agencés séparément par rapport à l'axe optique (O1) de la caméra de reconnaissance (50),
une première marque de repère (91) devant être capturée via le chemin optique de reconnaissance de carte (81) est agencée à une position prédéterminée sur le côté base (11),
une seconde marque de repère (93) devant être capturée via le chemin optique de reconnaissance de composant (82) est agencée à une position prédéterminée sur le côté tête de montage, et
des moyens de calcul (101) sont fournis qui calculent une valeur d'étalonnage en utilisant une relation de position des première et seconde marques de repère (91, 93) par rapport à l'axe optique (O1) de la caméra de reconnaissance (50) en capturant la première marque de repère (91) et la seconde marque de repère (93) en utilisant la caméra de reconnaissance (50).

2. Dispositif de montage de composant (10) selon la revendication 1, dans lequel la longueur du chemin optique de reconnaissance de carte (81) et la longueur du chemin optique de reconnaissance de composant (82) sont identiques.

3. Dispositif de montage de composant (10) selon la revendication 1, dans lequel la longueur du chemin optique de reconnaissance de carte (81) et la longueur du chemin optique de reconnaissance de composant (82) sont différentes, et leurs distances focales sont ajustées en utilisant une lentille relais (120).

4. Dispositif de montage de composant (10) selon l'une quelconque des revendications 1 à 3, dans lequel une seconde unité de miroir (80b), qui comporte le chemin optique de reconnaissance de composant (82), est prévue de manière à pouvoir être séparée par rapport à une première unité de miroir (80a) qui comporte le chemin optique de reconnaissance de carte (81), et la seconde unité de miroir (80b) peut être échangée pour correspondre à l'échange de la tête de montage (47).

5. Dispositif de montage de composant (10) selon l'une quelconque des revendications 1 à 4, dans lequel la première marque de repère (91) est prévue sur un rail fixe à la position de montage (P3).

6. Dispositif de montage de composant (10) selon l'une quelconque des revendications 1 à 5, dans lequel la tête de montage (47) est munie d'une pluralité de buses d'aspiration (55) sur la circonférence, et est munie d'une tête rotative (53) qui est capable d'indexer les buses d'aspiration (55) à une position de montage de composant (P1) et une position de capture de composant (P2), et un appareil de levage (70) qui soulève et abaisse les buses d'aspiration (55) qui sont indexées à la position de montage de composant (P1).

7. Procédé d'étalonnage dans un dispositif de montage de composant (10), le dispositif comprenant : une base (11) qui maintient une carte de circuit imprimé (B) de manière à être positionnée à une position de montage (P3) ; un chariot mobile (45) qui est supporté de manière à pouvoir se déplacer dans la direction d'axe X et dans la direction d'axe Y par rapport à la base (11); une tête de montage (47) attachée au chariot mobile (45) de manière à pouvoir être attachée et détachée avec une buse d'aspiration (55) qui aspire un composant (EP) alimenté par un dispositif d'alimentation en composants (20) et qui monte le composant (EP) aspiré par la buse d'aspiration (55) sur la carte de circuit imprimé (B) positionnée et maintenue à la position de montage (P3) et une caméra de reconnaissance (50) qui est munie intégralement du chariot mobile (45), le procédé étant **caractérisé en ce qu'**il comprend les étapes consistant à :
séparer un chemin optique de reconnaissance de carte (81) qui reconnaît une marque de carte (BM) qui est agencée sur la carte de circuit imprimé (B), et un chemin optique de reconnaissance de composant (82) qui reconnaît un composant (EP) aspiré dans la buse d'aspiration (55) par rapport à l'axe optique (O1) de la caméra de reconnaissance (50) ; et
étalonner une position de coordonnées de la buse d'aspiration (55) lors du montage de composants (EP) en obtenant une relation de position des première et seconde marques de repère (91, 93) par rapport à l'axe optique (O1) de la caméra de reconnaissance (50), et calculer une valeur d'étalonnage de la position de coordonnées de la buse d'aspiration (55) par rapport à la position de coordonnées de la première marque de repère (91) sur la base de la relation de position des première et seconde marques de repère (91, 93) par capture de la première marque de repère (91) qui est agencée sur le côté base et la seconde marque de repère (93) qui est agencée sur le côté tête de montage en utilisant la caméra de reconnaissance (50) via le chemin optique de reconnaissance de carte (81) et le chemin optique de reconnaissance de composant (82).
